# EUROPEAN PATENT SPECIFICATION

(11) **EP 2 121 511 B1**
(45) Date of publication and mention of the grant of the patent: **16.08.2017**
(21) Application number: 08705365.8
(22) Date of filing: 25.01.2008
(51) Int. Cl.: B81B 7/00, B81C 3/00, H01L 23/498, H01L 21/8234, H01L 21/762, B81C 1/00, H01L 23/26, H01L 23/14, H01L 23/055

(54) **METHOD OF PACKAGING AN ELECTRONIC OR MICROMECHANICAL COMPONENT**
VERPACKUNGSVERFAHREN EINES ELEKTRONISCHEN ODER MICROMECHANISCHEN BAUTEILS
PROCÉDÉ D' EMBALLAGE D'UN COMPOSANT ÉLECTRONIQUE OU MICROMÉCANIQUE

(30) Priority: 25.01.2007 SE 0700172
(43) Date of publication of application: 25.11.2009
(73) Proprietor: Silex Microsystems AB, 175 26 Järfälla (SE)
(72) Inventor: EBEFORS, Thorbjörn, S-141 41 Huddinge (SE); KÄLVESTEN, Edvard, S-129 38 Hägersten (SE); BAUER, Tomas, 197 91 Bro (SE)
(74) Representative: Brann AB
(86) International application number: PCT/SE2008/050093
(87) International publication number: WO 2008/091221

(56) References cited:
- EP-A1- 1 688 994
- EP-A2- 1 433 742
- WO-A1-2005/104228
- WO-A2-03/054927
- US-A1- 2003 047 798
- US-A1- 2003 089 394
- US-A1- 2004 259 325
- US-A1- 2005 023 547
- US-A1- 2005 127 499
- US-A1- 2005 218 488
- US-A1- 2006 063 462
- US-B1- 7 067 397

## Description

### Technical Field

The present invention relates to packaging of components for electronic devices, in particular devices requiring small components, such as but not limited to electrical and micromechanical surface micromachined oscillators for computers, mobile phones and the like.

### Background of the Invention

Certain components for surface mounting on circuit boards must be packaged in protective casings, quite often in vacuum or other controlled atmosphere/ambient and also need to be provided with connector legs for mounting or solder bumps for surface mounting. Today most encapsulating casings are made of polymers or ceramic materials. The latter is commonly used for packaged components that are hermetically sealed.

The inner compartment of such ceramic casings is made by milling processes. These processes have inherent drawbacks.

One thing is that the thickness of the package has an inherent lower limit. For e.g. mobile phone applications thickness is a vital parameter, and thus it would be desirable to further reduce the component thicknesses.

Sealing of individual packages is required, i.e. each individual item has to be handled separately for attaching a lid under vacuum, which requires elaborate equipment.

Also, there will always be rounded corners in the interior compartment because of the nature of the milling tools. Also, it is difficult to make very thin walls in such ceramic materials. This puts a lower limit of the size of such casings.

The smallest dimensions are dependent on the dimensions and the pitch between the interconnecting vias to the outside of the package. Package-through vias with small dimensions and small separation/pitch is desired to further reduce the package size.

Furthermore, there will be material incompatibility between the ceramic in the casing of the package and the components inside, which often are silicon based, as for example MEMS (Microelectromechanical Systems) devices. Differences in e.g. thermal expansion coefficients can cause artefacts.

WO-A-2005104228 discloses a method of micro-packaging a sensor component by joining first base and second lid semiconductor substrates separated by an intermediate semiconductor substrate consisting of a frame portion and a sensor portion. Electrical connections to the sensor are provided by electrical through connections in the base substrate. A depression is etched into the lid substrate above the sensor portion.

Other relevant disclosures are US-A-2006063462 and US-A-2003047798.

### Summary of the Invention

The object of the invention is to enable further miniaturization of such packaged components.

This object is achieved by the method as defined in claim 1. Hermetic sealing can be made at wafer-level using wafer bonding which significantly simplifies the manufacturing process thereby reducing costs.

Furthermore, a higher density of vias is possible in silicon based packages by using photolithography and etching processes than possible by using mechanical machining processes.

Further scope of applicability of the present invention will become apparent from the detailed description given hereinafter and the accompanying drawings which are given by way of illustration only, and thus not to be considered limiting on the present invention.

### Brief Description of the Drawings

Preferred embodiments of the invention will now be described with reference to the accompanying drawings, wherein
Fig. 1 shows in cross-section an example of a device that is useful for understanding the invention;
Fig. 2 shows another device useful for understanding the invention;
Fig. 3 is a perspective view of a micro-packaged device seen from the bottom side;
Fig. 4 is perspective view of a micro-packaged device from above with the lid taken off;
Fig. 5a is a perspective view similar to Fig. 3 but with a component to be mounted inside shown in shadow lines;
Fig 5b illustrates a similar device as in Fig 8(a) but having an insulating trench between the vias;
Fig. 6 illustrates packaging of monolithically integrated components with high density via structures;
Fig. 7 shows an array of contiguous vias;
Fig. 8 illustrates the geometry for corner etching of insulating trenches;
Fig. 9 shows a via with trench redundancy;
Fig. 10a illustrates (not to scale) an example wherein the micro-packaged device is made by forming the vias on a flat wafer and making a depression in the "lid wafer" to form a compartment for the component;
Fig. 10b illustrates an example wherein the micro-packaged device is made by forming a compartment by making a depression in both the via wafer and in the "lid wafer";
Fig. 10c illustrates a first embodiment wherein the compartment of the micro-packaged device is made by etching a hole in an intermediate substrate;
Fig. 11 illustrates a further example wherein a discrete component is surface mounted on the via wafer;
Fig. 12a illustrates a further example wherein the component is provided using surface micromachining;
Fig. 12b illustrates a further example wherein the component is connected to one through wafer connection and in addition directly to the via wafer;
Fig. 13 illustrates a micro-packaged component manufactured using a SOI wafer and having an insulating trench separating through wafer connections; and
Fig. 14 illustrates a micro-packaged device useful for understanding the invention wherein the component is mounted on the "lid wafer"; and
Fig.15 illustrates a bulk micromachined component integrated with an intermediate substrate.

### Detailed Description of Preferred Embodiments

Electrical through connections (or "vias"), enable connection of packaged micro-components to circuit boards or to other components with the provision of bulky connector legs or pins, and wafer-level hermetic encapsulation. The terms electrical through connection and via are interchangeably used in this application.

Preferably the starting wafers having said vias are semiconductor wafers, more preferably single crystalline silicon wafers, however not limited to this. The term "semiconductor wafer" also comprises other wafer materials typically used in the field, such as glass wafers and ceramic wafers. The terms wafer and substrate are interchangeably used throughout this application since processing preferably is made on wafer level, i.e. many devices are manufactured in parallel.

Preferably, the packaged component is made by using a wafer having been provided with vias in accordance with the teachings of the International Patent Publication WO 2004/084300 A1 (Silex Microsystems). In particular the invention of WO2004/084300 relates to a method of making an electrical through connection between a first (top) and a second (bottom) surface of a semiconductor substrate. The method comprises creating a trench in the first surface and establishing an insulating enclosure entirely separating a portion of said substrate, defined by said trench, i.e. an insulated through connection. One product manufactured according the method is usable as a starting substrate, a so called interposer, for further manufacturing of micro-electronic and/or micro-mechanic devices. One advantage of this kind of product (interposer) is that the through connections are made of the wafer material and therefore are suitable for the processing usually applied to such wafers, i.e. the wafers can withstand temperatures, chemicals that commonly are used in conventional processing of semiconductor wafers. Another advantage of a wafer having these vias is that the wafer may have a thickness of 300-700µm, which makes it possible to handle the wafers during the further processing.

For different applications, such as RF (radio frequency) applications comprising e.g. switches or resonators, there is a need for low resistivity through wafer connections. For such applications other via technologies than the one explained above using the wafer material or e.g. polysilicon as a conductor may have to be used. The international patent application WO 2007/089206 teaches a method to provide a wafer with closely spaced metallic through wafer connections. This wafer is also suitable as a starting substrate for further manufacturing of electronic and or micro-mechanic devices.

Another kind of starting substrates with pre-made vias is a so called SOI (silicon on insulator) wafer, wherein the pre-made vias are made in the device layer of the wafer, i.e. not extending entirely through the whole wafer. The through connections are instead exposed in subsequent process steps.

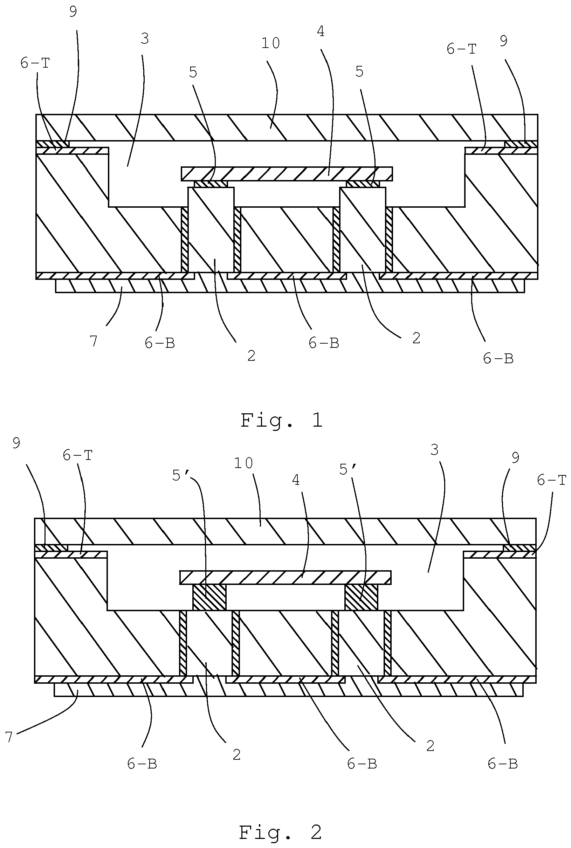

Thus, the starting substrate for the process according to the invention is a wafer 1 having pre-made vias 2, as can be seen in Figs. 1 and 2. These figures and the following figures are not drawn to scale and serve to illustrate the invention.

The starting wafer should be thicker than about 300µm in order to provide enough rigidity to enable handling of the wafer during processing without risk of breaking it. Preferably the starting wafer comprising the through wafer connections has a thickness of > 100µm, preferably >200µm, more preferably >300µm, still more preferred >400µm, and most preferred >500µm.

Referring to Fig. 1, in an example not forming part of the invention, the wafer is first subjected to a patterning to define the compartments 3 in which the components 4 are to be mounted. Example of components are e.g. all kinds of MEMS devices (sensors and actuators), either in discrete form or monolithically integrated on silicon; capacitors and/or resistors of various materials; EMC Components such as EMI Filters, Transient Voltage Suppressors; Timing Devices such as Crystal Units, Clock Oscillators, TCXO, VCXO, High Precision Oscillators for Industrial Applications, Ceramic Resonators, SAW Resonators; Crystal Products of various kinds; Filters such as SAW Filters, Monolithic Crystal Filters; RF Modules such as Antenna Switch Module; Piezo Products such as Shock Sensors, Piezoelectric Acoustic Generator Elements, Piezo Buzzers.

For the purpose of this application the term "compartment" 3 refers to a volume that has been formed in one or a plurality of substrates in order to receive a component, which subsequently is encapsulated therein. The compartment 3 may, before the encapsulation, be a depression 3a or a hole 3b in one or in a plurality of the substrates (1, 10, 11).

A suitable etch is applied to the patterned wafer, and a suitably shaped depression, typically rectangular but not limited to this, is thus formed in any of the via wafer or the lid wafer or in both. An advantage with an etching process as compared to the prior art milling, is that it is possible to make very sharp corners in the "box"-like depression, and furthermore silicon processing using lithography and etching enables making very small "boxes" with accurate dimensions. Then, a second pattern is applied to define mounting members corresponding to the vias 2, i.e. the surface of the vias 2 are covered with etch resistant material. A second etch is applied to etch a deeper depression, whereby protruding members 2 are formed. The depression is suitably 150µm deep, and the height of the protruding members is suitably of the order 20µm, but these measures can of course vary depending on the application in question.

On top of these protruding members 2 pads 5 or bumps of gold (Au), solder, AuSn., PbSn, etc. are formed by any suitable method such as plating, sputtering etc. If the box is made in the lid wafer 10 these bumps 5 are preferably made on the flat via wafer 1 which simplifies the manufacturing.

The component 4 to be mounted in the protective casing can be attached directly to the through wafer connections 2 e.g. by soldering, ultrasonic welding, gluing and wire bonding, in an automated processing using standard surface mounting machines. "Directly" is for the purpose of this application interpreted to mean that there is no additional routing needed to form a contact pad, but as illustrated in Fig. 1 there may be e.g. pads 5 or bumps in-between the component 4 and the through wafer connection 2. By attaching the component 4 directly to the vias the component 4 can be place immediately above the through connections 2. When the component 4 is in place, the entire wafer 1 is put in a vacuum and a lid 10 is applied to cover the entire wafer 1. For bonding the lid 10 to the component wafer 1, there are several options available.

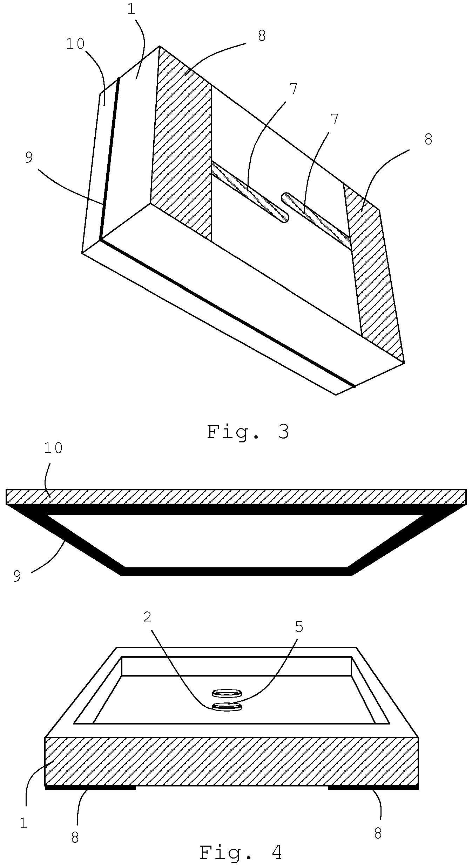

Fig. 3 illustrates a micro-packaged device having large contact areas 8 on the bottom side of the device. The routing 7 connects the large contact areas 8 with the through connections 2 which extends into the sealed package.

Referring to Fig. 4, one can apply a "frame" 9 of gold on the lid wafer corresponding to the size of the package, i.e. a strip of gold having the same dimensions as the package, such that when the lid wafer is aligned to the component wafer, pressure and heat is applied, there will be a eutectic bonding between the lid 10 and the silicon in the wafer 1. In this case the insulating layer 6-T is not applied.

On the other hand the gold can be applied to the layer 6-T and instead having the lid "silicon clean", i.e. letting the silicon in the lid 10 bond to the gold on the component wafer 1.

A second method is to apply a gold layer on both the lid wafer 10 and the component wafer 1 and apply what is referred to as a thermocompression bonding process.

Thirdly, a solder (e.g. PbSn or AuSn) can be applied on one of the wafers (1, 10, 11) and gold on the other and a soldering process is made.

Optionally the bonded wafers can be grinded or polished to reduce the total thickness to a desired thickness suitable for the application in question. E.g. for mobile phones thin packages are essential.

On the back side of the wafer 1 an insulating layer 6-B of e.g. oxide, or any other suitable material is applied. This layer could have been applied before any other processing is done, as could the insulting layer 6-T on the top side of the wafer. In this layer 5 openings are made by patterning/etching to expose the via to enable contacting to other components or to a circuit board. Suitably there is provided a metallization 7 of e.g. A1 that contacts the via material and can be provided as narrow contact strips from the via to the edges of the entire packaged structure. This can be seen in the bottom view in Fig. 3, wherein the Al-strips 7 are shown. At the edges there can be provided larger contact areas 8 for further bonding, commonly referred to as bumps. The skilled man will find possible means for this without inventive work, but as an example can be mentioned various kinds of solder (Pb/Sn, Au/Sn, etc.) for soldering or "flip-chip" mounting. The package can be provided with so called Under Bump Metallization (UBM) and the solder provided on the circuit board, but the solder can also be provided on the package. Although the figures show only one micro-packaged device, it is to be understood that there can be made several thousand items on one wafer in one batch. With this wafer-level packaging approach according to the invention it is possible on a wafer level to provide several thousands of micro-packaged components wherein the exterior dimensions can be made substantially smaller than with presently used technology.

In a final step in a manufacturing process the wafers are cut up in individual micro-packaged components by e.g. sawing.

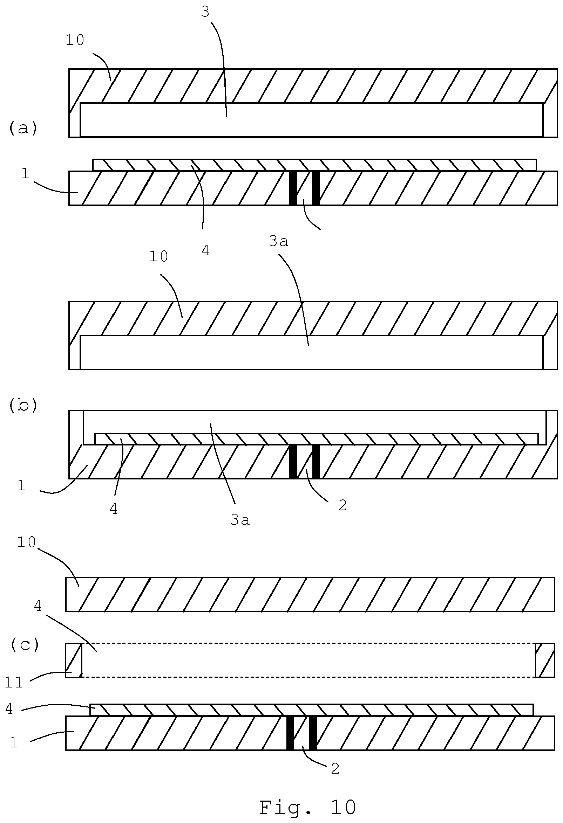

Referring to Fig. 2, the bump structures are not made from the vias 2. Instead the depression 3 is made in one etching step, either on the via wafer or the lid wafer or both (as illustrated in Fig. 10). Thereafter gold bumps 5' are provided such that they exhibit the same height as the protruding members 2 in Fig. 1. These gold bumps 5' can then be used for attaching a component 4 in a similar fashion as described in connection with Fig. 1.

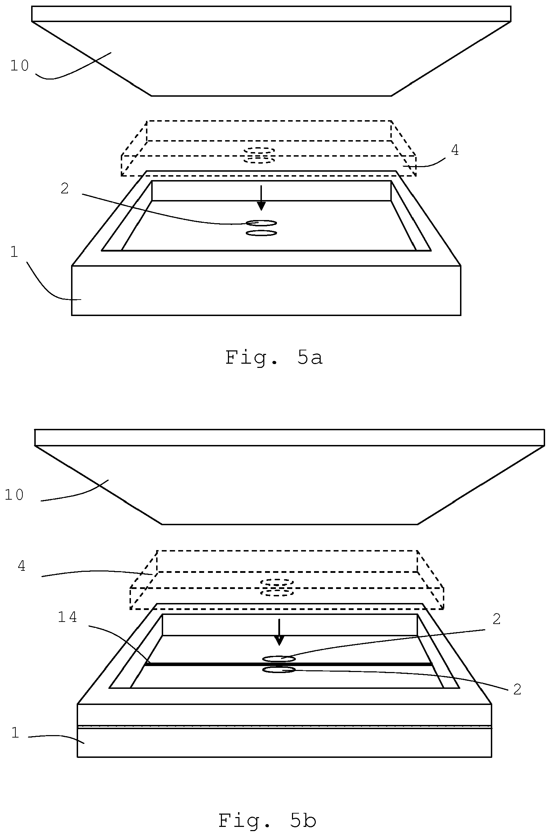

Fig. 5a illustrates a component 4 which is provided immediately above a depression 3a forming a compartment 3 in a a first semiconductor substrate 1 comprising two through connections extending entirely through the first substrate 1 to the bottom side thereof. The through connections are protruding into the depression. A second substrate 10 is arranged above the component 4. After surface mounting of the component directly to the through wafer connections the compartment is sealed by joining the substrates together to form a sealed micro-packaged device. Fig. 5b illustrates a similar arrangement as shown in Fig. 5a but the first substrate having the through connections 2 is a SOI substrate. In addition the first substrate 1 comprises an insulated trench 14 extending entirely through the first substrate 1. The insulating trench 14 is electrically insulating one portion of the first substrate from another, each portion comprising one of the two through wafer connections 2. Thereby the capacitive coupling between the through connections 2 is reduced and in addition, due to the insulating layer between the bulk Si layer and the device layer of the SOI substrate there is a vertical electrical insulation in the device.

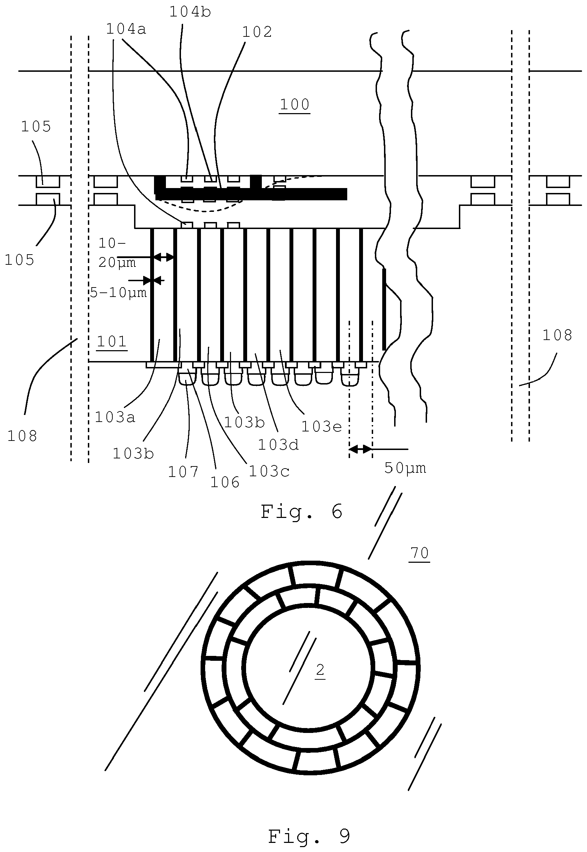

Referring to Fig. 6, the reference numerals are used as follows: 100 is a "lid wafer" on which a movable switch 102 is provided, comprising a flexible membrane (the flexing during actuation is shown with a broken line). 101 is a wafer comprising an array of high-density vias 103a-e. 103a is a "dummy" via used for etch load compensation, 103b is used for actuation purposes, 103c is a signal via, 103d is coupled to ground, 103e is another actuation via, 104a and 104b are electrostatic actuation pads, 105 designates Au pads for thermo compression bonding. 106 is a UBM and 107 is a solder bump. 108 are sawing traces.

Fig. 6 illustrates wafer level packaging which enables a considerable decrease in the pitch distance between two neighbouring vias. This is a great advantage that can be obtained when silicon is used for fabricating the hermetic sealed wafer through -connections. On the lid wafer, that preferably is a silicon wafer or a transparent glass wafer, micro structures (e.g. switches or micro mirrors) are integrated in large array configurations using surface micromachining technologies well known to the man skilled in art.

Using the silicon via technology, disclosed in Swedish patent No. SE-526 366 (Silex) a great advantage can be obtained. Namely, the device can be substantially simplified since all lateral metal routing could be avoided because of the vias located immediately below each component. However, routing on both wafers (i.e. component and lid wafer, respectively) and both the front side and back side of the via wafer is still possible to do like in prior art techniques (compare Fig. 3 and Fig. 6). Especially for switch applications for RF signals the possibility to make micro strip line layouts is a great advantage. Fig. 6 illustrates an example of a device having a large array of identical sub components (=double suspended membrane switch structures (102)). The signal contacts (104b) on the membrane are individually switched by electrostatic actuation pads (104a). In order to make the array of switches as small as possible high density arrays of vias (103b-e) are needed.

Wafer level encapsulation of these microstructures under vacuum (or other controlled ambient) is obtained by bonding the LID wafer and via wafer together. Among the different wafer level bonding alternatives are:
- Au-Au for thermo compression bonding
- AuSn, PbSn etc against Au etc for solder bonding
- Au-Si for eutectic bonding
- Si-Si, SiO-Si or SiO-SiO (or other alternative isolating materials such as SiN) for fusion bonding (optional plasma enhanced low temp bonding)
- Si-glass for anodic bonding (optional A1 on Si for A1/glass anodic bonding)

Among the many available ways of adding these bonding materials on the wafer are (but not limited to): conventional sputter/evaporation metallization followed by photolithography and etching, lift-off, shadow evaporation/sputtering, screen printing, preform.

Bonding alternatives as well as methods for applying the materials are well known for the skill man in art.

After the two wafers are bonded together processing as described in Fig 3 is made. There exist several different methods for under bump metallization-UBM (maybe with routing-7), with the option of adding solder bumps-8 for flip-chip surface mounting. An overview of these different technologies are found in for example article "The Use of Solder as an Area-Array Package Interconnect" by Dr. Ning-Cheng Lee in Sept-Oct-99 number of Chip Scale Review (available at http://www.chipscalereview.com/issues/1099/featured1.htm). For tight via pitch applications (i.e. via pitches less than 150 µm) the solder bumping is preferably made by the photo lithography and electroplating process.

For certain applications it may be necessary to provide wafer through connections by "vias" that are so closely spaced that it will be impossible to make separate vias having the necessary close pitch. A typical centre-to-centre distance for circular vias is about 250µm, if trenches are 10-30µm wide and the diameter of vias is 100µm. The starting wafer is typically 300-450µm in order to be processed without a handling wafer attached thereto. For such thickness of the wafer the typical trench width is 15-20µm and the via diameter is about 50-100µm.

Closely spaced through wafer connections can also be accomplished if using a SOI-substrate having a device layer thickness of about 50-200µm, as illustrated in Fig. 5b. For a device layer thickness of 100µm a typical trench width is about 5µm and the via diameter is about 20 µm.

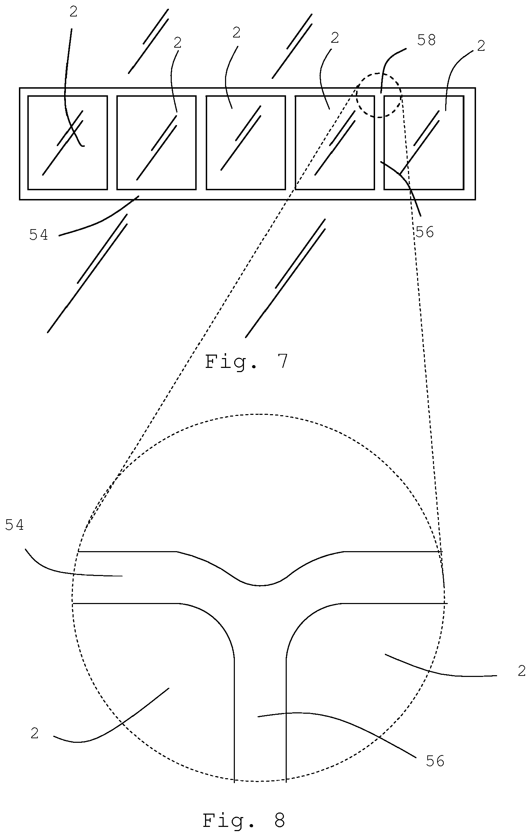

However, referring to Fig. 7, the inventors have devised a method of making very closely spaced vias, and an example of such vias 2 is schematically shown in Fig. 5 as a top view of a portion of a wafer or substrate 1 having the novel vias provide therein (see also Fig. 6). The filled trenches are designated 54. The idea is to let neighbouring vias share a common insulated trench as at 56 in Fig. 7. A typical centre-to-centre distance for these vias is about 50µm, if trenches are 5-10µm wide and the side dimension of vias is, typically 35µm.

However, in the process of making arrays of contiguous vias of this type, the problem of varying etch performance over the surface of a wafer is noticeable and will have an influence on the result. In order to make what is referred to as an "etch load compensation", there will always be made a redundant via at each end of the array. These outermost vias in the array will not be used in operation of the array, but are only present for the above mentioned reason. See Fig. 6, item 103a.

However, there is a further problem associated with the manufacture of this kind of via arrays. This problem occurs in the corners where trenches meet, i.e. at 58 in Fig. 7. What happens is that the applied etch will act on the wafer material from two or more directions (depending on the number of trenches that meet), and the result is that the depth to which the etch will reach will vary and become deeper at the corners. The etch will therefore penetrate through the wafer or reach a stop layer at different times in different locations, which could be detrimental to the result.

Referring to Fig. 8, in order to eliminate or at least reduce this problem to be insignificant, the corners are given a special geometry, which corresponds to the encircled part shown at 58 in Fig. 7. The optimal shape can be determined based on etching parameters used for each specific case. Shaping the trenches like this will ideally result in trenches having essentially the same depth, or at least will the etch not be too deep in the corners of the trench structure.

A still further problem can occur with very long trenches, i.e. where the "via" itself occupies a large surface area on the wafer. Namely, in view of the trenches in a standard situation are about 8µm wide, it will suffice if one single particle with conductive properties gets "caught" in the trench and forms a bridge between the via and the surrounding wafer material in order that the via will be shortcircuited. The probability of this happening becomes increasingly larger as the length of the trench increases, and will inevitably cause high rejection rates and thus low manufacturing yields.

By making a trench structure introducing a redundancy, this problem can be ameliorated.

The way this is solved is as follows. Referring to Fig. 9, two or more trenches are made as concentric circles or squares or rectangles or any other geometric shape on a wafer or substrate 1, enclosing a via 2, and each circle is connected to the next by radially extending trenches, as shown in Fig. 9, wherein three concentric trenches are connected by the radial trenches.

Fig. 10a-c illustrates different ways to accomplish a compartment 3 for a component 4 to be hermetically sealed. A first substrate 1 having at least one through connection 2 extending entirely through the substrate 1 is provided. The component 4 is directly attached and connected to the through connection 2. Thereby the through connection is covered by the component 4.

As illustrated in Fig. 10a, in one example a depression 3a is etched in a second substrate 10. The depression defines the compartment 3 and by joining the substrates 1, 10 the compartment 3 is sealed.

As illustrated in Fig. 10b depressions 3a are etched in each of the first substrate and the second substrate 1,10, whereby the depressions 3a define the compartment 4. The substrates 1, 10 are joined together and the compartment 3 containing the component 4 is sealed.

As illustrated in Fig. 10c, in accordance with a first embodiment of the invention, an intermediate substrate 11 is provided in addition to the first and second substrates 1, 10. A hole 3b defining the compartment 3 is etched in the intermediate substrate 11 and the three substrates 1, 10, 11 are joined whereby the compartment 3 containing the component 4 is sealed.

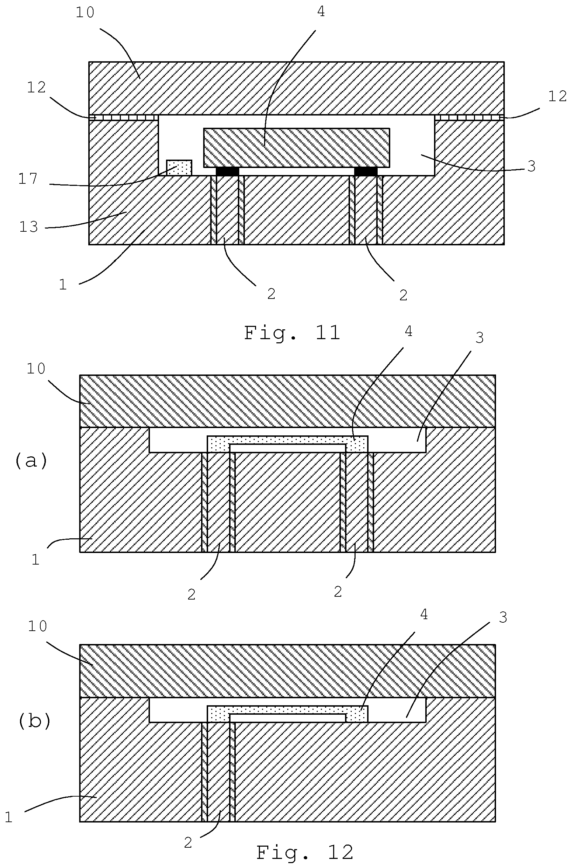

Referring to Fig. 11, in a further example useful for understanding the present invention the micro-packaged device 15 comprises a first and second semiconductor substrate 1, 10, which are joined together. The first semiconductor substrate 1 comprises a depression 3a, whereby the first and the second semiconductor substrates 1, 10 form a sealed compartment 3 in-between. Trough connections 2 are extending entirely through the first substrate 1 from the bottom of the compartment 3 to the other side of the first substrate 1. A micro-electronic or a micro-mechanic component 4, such as e.g. an ASIC or a resonator crystal, is attached directly to the through connections 2 within the sealed compartment 4. A micro-component 4 is attached directly on pads located on two through connections 2, which are extending entirely through a first semiconductor substrate. A getter plate 12 is deposited on the first substrate 1 within the compartment 3. The through connections 2 are by way of example made in the same material as the first substrate and are electrically insulated by a trench enclosing each via connection.

The first and the second substrates are by way of example joined by an Au-Si eutectic joint.

In the first step of the manufacturing of the micro-packaged component in Fig. 11 a first substrate 1 and a second substrate 10 are provided. The first substrate is at least 300 µm, preferably at least 500 µm thick, and comprises the electrical through connections 2, which are extending entirely though the first substrate 1. The second substrate 10 may be thinner than the first substrate 1 since it is not processed to such a large extent that the handling becomes a problem, preferably the thickness is however at least 300 µm. Although Fig. 11 shows only one micro-packaged device 15, it is to be understood that there preferably is made a large number of micro-packaged devices in parallel in one batch, i.e. the first and second substrates 1,10 are wafers being large enough for making the large number of micro-packaged devices. As mentioned above the wafers should have a sufficient thickness and the through connections 2 are made of the wafer material, in order to be compatible with conventional processing steps used in the field. A depression 3a is formed in the first substrate 1 using photolithography and etching, such as wet etching or dry etching, in such way that the through connections 2 are exposed in the bottom of the depression 3a. The depth of the depression 3a is dependent on the thickness of the component to be packaged, but typically the thickness is about 150 µm. The through connections 2 at the bottom of the depression 3a of the first substrate 1 are bumped and the component 4 is attached to the bumps. Different methods, such as wafer level flip-chip mounting, thermo compression bonding, gluing, wire bonding etc., can be used to attach the component 4. By way of example a gold layer is applied on the second wafer, at least in an area intended to be brought in contact with the first substrate to form the joint. The second substrate 10 or the lid is aligned to the first substrate 1 and pressure and heat is applied, which gives a eutectic bonding between the first and second substrates 1,10 and a sealed compartment 3 containing the component 4 is formed. The eutectic bonding is performed at relatively low temperatures (about 360°C), which makes it a suitable bonding method when the attachment of the component 4 have yielded a temperature sensitive joint between the component and the through wafer connection. So far all processing is preferably made on wafer-level in one batch. Individual micro-packaged components are typically formed using dicing. In this description of the manufacturing many of the steps or details thereof are on purpose not disclosed since these steps are well known by a person skilled in the art.

In a micro-packaged device manufactured according to the present invention it is possible to obtain a controlled atmosphere, i.e. vacuum, protective gas, etc., in the sealed compartment. The long term stability of this controlled atmosphere is dependent on the gas permeability of the joint between the wafers of the package, the gas permeability of the wafers and release of gases from components or other structures enclosed within the compartment. Preferably a getter means 17 in the form of e.g. a plate, a thin film, a bump, etc. is enclosed within the compartment to remove gas molecules that find its way into the compartment. A person skilled in the art is familiar with the different getter materials used, since such is commonly used in other hermetically sealed devices.

There are several alternatives to the eutectic bonding that provide bonding at low temperatures, such as thermocompression bonding or solder bonding. AuSn to Au bonding is for example performed above 280°C but there is other solders having lower melting temperature. Another alternative is plasma enhanced bonding, whereby the micro-packaged component has to withstand at least 400°C. Ther are also polymer bonding methods which can be used to join the substrates of the micro-packaged component.

Fig. 12 illustrates a micro-packaged device. The component 4 is a monolithically integrated component, by way of example a polysilicon structure, intended to be used e.g. as a resonator structure or accelerometer structure. The polysilicon structure attached to the through wafer connections of the first substrate 1 but is in between these attachment points free-hanging. The polysilicon structure is fabricated on the first substrate after etching the depression 3a using surface micromachining, which may comprise e.g. sacrificial oxide etching to form a gap between the polysilicon structure and the bottom of the depression 3a. Such a polysilicon structure can in contrast to e.g. an assembled ASIC withstand high temperatures and since neither the first substrate 1 or the second substrate 10 comprise any other temperature sensible parts, high temperature joining processes such as fusion bonding can be used. By way of example the first and the second substrate 1,10 of the micro-packaged device in Fig. 12 are activated in the processing step that removes the sacrificial oxide to and thereafter immediately aligned and fusion bonded, preferably at a temperature of about 900-1000°C to form a sealed package.

One advantage with fusion bonded micro-packaged devices is that the package can be made even smaller. The fusion bonding provides a good sealing and the sealing area can be made smaller than for e.g. thermocompression bonding. Furthermore the bond strength may be so high that a possible breakage of the package will likely take place in the substrate and not in the joint between the substrates.

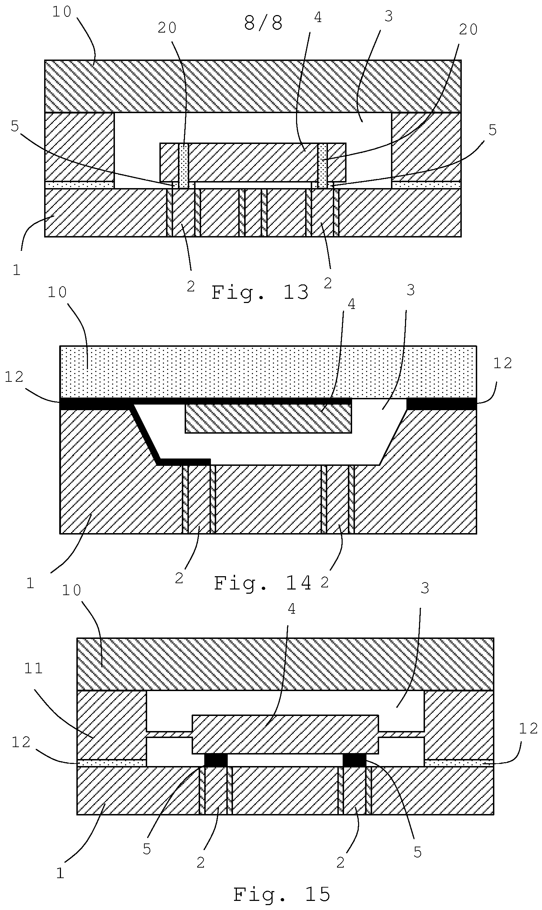

Fig. 13 illustrates a micro-packaged device similar to the micro-packaged device in Fig. 12. In this case the packaged component 4 is formed in the same material as the first substrate 1. The first substrate 1 comprises a buried oxide layer dividing the first substrate 1 in a device layer and a bulk layer. The thickness of the device layer is usually thinner than the bulk layer, by way of example 100µm and 300-400µm, respectively. The through connections 2 extend through the device layer and ends in the buried oxide layer which has been removed in an area about the through connections 2. A single crystalline micro-mechanic structure, such as a resonator structure or an accelerometer structure, formed by etching of the bulk layer and sacrificial etching of the buried oxide layer, is attached to the through connections 2. The micro-mechanic structure is formed, preferably in the same process step, in a depression 3 that is etched out in the bulk layer of the first substrate 1. Also in this case the first and second substrate 1, 10 and the constituting parts thereof allow fusion bonding, which preferably is performed immediately after activation in the step of sacrificial etching of the buried oxide layer. A vapour of HF may be used for this activation. Furthermore, the bulk micromachined component is electrically anchored to the first substrate by a filled hole 20 extending entirely through the component 4 and the buried oxide layer between the component and the first substrate 1 down to the through wafer connections. The filled hole 20 is filled with polysilicon which provides an electrical connection between the component 4 and the through connections 2.

Fig. 14 illustrates a micro-packaged device comprising a first substrate made of a semiconductor material such as monocrystalline silicon and a second substrate 10 made of glass. The first substrate 1 comprises an array of through connections 2 extending entirely through the first substrate 1 to form electrical connections between the bottom of a depression to a second (lower) side of the first substrate 1. The first and the second substrate 1, 10 are joined together to form a sealed compartment 3, wherein a microelectromechanical component 4 is integrated on the surface of the second substrate 10 within the compartment 3. The first and the second substrates 1,10 each comprises e.g. a gold layer, which is patterned in order to connect at least one of the through connections 2 in the first substrate 1 with the microelectromechanical component 4 on the second substrate 10. This is accomplished by a strip of the gold layer extending from a through connection 2 along the bottom of the compartment 3 and up along the sidewall of the compartment 3 to the joint between the first and second wafers 1, 10, wherein the gold layer of the first and second wafers are in contact. From there a strip of gold extends to the microelectromechanical component 4. The first and second substrates 1,10 are joined together using thermocompression bonding by applying a high pressure at about 400°C, whereby the gold layers adhere to each other. In one example the micro-packaged device 15 is formed using a first and a second substrate 1,10 and at least one intermediate substrate 11. At least the first substrate 1 comprises through connections 2 extending entirely through the first substrate 1 into the compartment 3. The compartment 3 for the component 4 is formed by etching a hole through the intermediate substrate and joining the first, the second and the intermediate substrate. Fig. 15 illustrates this case. The component 4 is monolithically integrated with the intermediate substrate 11 and is formed by bulk micromachining of the intermediate substrate 11. The bulk micromachining both defines the shape of the component 4 and defines at least a portion of the compartment wherein the component 4 is to be packaged. As illustrated in Fig. 15 the component (or the through wafer connections of the first substrate 1) is provided with bumps 5 before joining the substrates and sealing the compartment 3.

Usually ceramic materials are used to package and hermetically seal electrical and micromechanical components, but the smallest packages available are about 3x2mm² and with a thickness of more than 1mm. This technology does not allow substantial miniaturisation. The present invention provides substantially smaller packages. The thickness is preferably less than 0.6mm and the lateral dimensions are preferably less than 1x1mm², depending on the size of the component.

While the invention has been described in connection with what is presently considered to be the most practical and preferred embodiments, it is to be understood that the invention is not to be limited to the disclosed embodiments, on the contrary, is intended to cover various modifications and equivalent arrangements within the appended claims.

A sealed micro-package 15 suitably has a thickness of <2mm, preferably <1mm and more preferably <0.6mm, and has lateral dimensions less than 2x2mm², preferably less than 1x1mm².

In the method of micro-packaging a component 4 according to the invention, the step of providing the component 4 further comprises the step of attaching the component 4 directly to the through connections 2. In the method of micro-packaging a component 4 the through connections (2) can be made of the substrate material, or of a metal or a metal alloy. In the method of micro-packaging a component 4 cutting up individual packages is made e.g. by sawing. The method of micro-packaging a component 4can comprise a step of providing getter means (17) in the compartment (3).

## Claims

1. A method of micro-packaging an electronic or micromechanical component (4), comprising the steps of:
providing a flat first substrate (1), a flat second substrate (10), and an intermediate semiconductor substrate (11), the first substrate (1) being a semiconductor substrate and being provided with an electrical through connection (2) extending entirely through the substrate;
etching a hole (3b) through an entire thickness of the intermediate semiconductor substrate (11);
providing the component (4) above the first flat surface of the first semiconductor substrate (1) so that the component (4) covers at least the through connection (2) and connecting the component (4) directly to the through connection (2); and
joining the first substrate (1), the second substrate (10) and the intermediate semiconductor substrate (11), the intermediate semiconductor substrate joined to the first substrate such that such that the hole (3b) of the intermediate semiconductor substrate (11) forms a compartment (3) that houses the component (4), and the second substrate (10) being joined to the intermediate substrate opposite the first substrate to form a lid over the compartment (3) for sealing the compartment,
wherein the component (4) is a discrete component which is attached by surface mounting such as any of flip chip mounting, soldering, ultrasonic welding, thermocompression bonding, gluing,
wherein the first substrate (1) has a thickness of >100µm.

2. The method of micro-packaging a component (4) according to claim 1, **wherein** the first substrate (1) is provided with a plurality of through connections (2).

3. The method of micro-packaging a component (4) according to claim 1 or 2, **wherein** the second substrate (10) is a semiconductor substrate.

4. The method of micro-packaging a component (4) according to any of claims 1-3, **wherein** the first substrate (1) which is provided with electrical through connections (2) has a thickness of >200µm, more preferably >300µm, still more preferred >400µm, and most preferred >500µm.

## Patentansprüche

1. Verfahren zum Mikroverpacken eines elektronischen oder mikromechanischen Bauteils (4), aufweisend die folgenden Schritte:
Bereitstellen eines flachen ersten Substrats (1), eines flachen zweiten Substrats (10), und eines zwischenliegenden Halbleitersubstrats (11), wobei das erste Substrat (1) ein Halbleitersubstrat ist und mit einer elektrischen Durchgangsverbindung (2) versehen ist, die sich vollständig durch das Substrat erstreckt;
Ätzen eines Lochs (3b) durch eine gesamte Dicke des zwischenliegenden Halbleitersubstrats (11);
Bereitstellen des Bauteils (4) oberhalb der ersten flachen Fläche des ersten Halbleitersubstrats (1), so dass das Bauteil (4) mindestens die Durchgangsverbindung (2) abdeckt, und Verbinden des Bauteils (4) direkt mit der Durchgangsverbindung (2); und
Verbinden des ersten Substrats (1), des zweiten Substrats (10), und des zwischenliegenden Halbleitersubstrats (11), wobei das zwischenliegende Halbleitersubstrat mit dem ersten Substrat verbunden wird, so dass das Loch (3b) des zwischenliegenden Halbleitersubstrats (11) eine Kammer (3) bildet, die das Bauteil (4) aufnimmt, und das zweite Substrat (10) mit dem zwischenliegenden Halbleitersubstrat, entgegengesetzt zu dem ersten Substrat, verbunden wird, um einen Deckel über der Kammer (3) zum Abdichten der Kammer zu bilden,
wobei das Bauteil (4) ein diskretes Bauteil ist, das durch eine Oberflächenmontage, wie beispielsweise eine beliebige einer Flip-Chip-Montage, eines Lötens, eines Ultraschallschweißens, eines Thermokompressionsbindens, eines Klebens, angebracht wird,
wobei das erste Substrat (1) eine Dicke von > 100 µm hat.

2. Verfahren zur Mikroverpackung eines Bauteils (4) nach Anspruch 1, **wobei** das erste Substrat (1) mit mehreren Durchgangsverbindungen (2) versehen ist.

3. Verfahren zur Mikroverpackung eines Bauteils (4) nach Anspruch 1 oder 2, **wobei** das zweite Substrat (10) ein Halbleitersubstrat ist.

4. Verfahren zur Mikroverpackung eines Bauteils (4) nach einem der Ansprüche 1 bis 3, **wobei** das erste Substrat (1), das mit elektrischen Durchgangsverbindungen (2) versehen ist, eine Dicke von > 200 µm, mehr bevorzugt > 300 µm, noch mehr bevorzugt > 400 µm, und am meisten bevorzugt > 500 µm hat.

## Revendications

1. Procédé de micro-emballage d'un composant électronique ou micromécanique (4), comprenant les étapes consistant à :
fournir un premier substrat plat (1), un second substrat plat (10) et un substrat à semi-conducteur intermédiaire (11), le premier substrat (1) étant un substrat à semi-conducteur et étant pourvu d'une connexion électrique traversante (2) s'étendant entièrement à travers le substrat ;
graver un trou (3b) à travers l'épaisseur entière du substrat à semi-conducteur intermédiaire (11) ;
fournir le composant (4) au-dessus de la première surface plate du premier substrat à semi-conducteur (1) de sorte que le composant (4) recouvre au moins la connexion traversante (2) et connecter le composant (4) directement à la connexion traversante (2) ; et
joindre le premier substrat (1), le second substrat (10) et le substrat à semi-conducteur intermédiaire (11), le substrat à semi-conducteur intermédiaire étant joint au premier substrat de sorte que le trou (3b) du substrat à semi-conducteur intermédiaire (11) forme un compartiment (3) qui reçoive le composant (4) et le second substrat (10) étant joint au substrat intermédiaire opposé au premier substrat pour former un couvercle par-dessus le compartiment (3) afin d'étancher le compartiment,
dans lequel le composant (4) est un composant discret qui est fixé par montage en surface, notamment par montage flip-chip, brasage, soudage ultrasonique, liaison par thermocompression, collage,
dans lequel le premier substrat (1) a une épaisseur supérieure à 100 µm.

2. Procédé de micro-emballage d'un composant (4) selon la revendication 1, **dans lequel** le premier substrat (1) est pourvu d'une pluralité de connexions traversantes (2).

3. Procédé de micro-emballage d'un composant (4) selon la revendication 1 ou 2, **dans lequel** le second substrat (10) et un substrat à semi-conducteur.

4. Procédé de micro-emballage d'un composant (4) selon l'une quelconque des revendications 1 à 3, **dans lequel** le premier substrat (1) qui est pourvu de connexions électriques traversantes (2) a une épaisseur supérieure à 200 µm, mieux encore supérieure à 300 µm, bien mieux encore supérieure à 400 µm et nettement mieux encore supérieure à 500 µm.
